# EUROPÄISCHE PATENTSCHRIFT

(11) **EP 1 258 919 B1**
(45) Veröffentlichungstag und Bekanntmachung des Hinweises auf die Patenterteilung: **21.02.2007**
(21) Anmeldenummer: 02010015.2
(22) Anmeldetag: 04.05.2002
(51) Int. Cl.: H01L 21/762, H01L 21/20

(54) **Verfahren zur Herstellung eines Silizium-Wafers**
Method of manufacturing a silicon wafer
Méthode de fabrication d'une plaquette de Silicium

(30) Priorität: 16.05.2001 DE 10124030
(43) Veröffentlichungstag der Anmeldung: 20.11.2002
(73) Patentinhaber: ATMEL Germany GmbH, 74072 Heilbronn (DE)
(72) Erfinder: Dietrich, Harry, 74912 Kirchardt (DE); Dudek, Volker, Dr., 74336 Brackenheim (DE); Schüppen, Andreas, Dr., 74348 Lauffen (DE)

(56) Entgegenhaltungen:
- EP-A- 0 779 650
- EP-A- 0 936 663
- US-A- 5 476 813

## Beschreibung

Die vorliegende Erfindung betrifft ein Verfahren zur Herstellung eines Silizium-Wafers mit einer isolierenden Zwischenschicht.

Ein derartiges Verfahren zur Herstellung eines Silizium-Wafers mit einer Oxidschicht als isolierender Zwischenschicht, nachfolgend SOI-Wafer genannt, ist aus der Druckschrift EP 1 045 448 A bekannt. In dem beschriebenen Verfahren, das auch als "SMART CUT" bekannt ist, wird ein erster Silizium-Wafer oxidiert und anschließend mittels einer Wasserstoffimplantation in einer durch die Implantationsenergie vorgegebenen Tiefe eine wasserstoffreiche Schicht erzeugt. Danach wird die Oberfläche des ersten Wafers mit der Oberfläche eines zweiten Wafers zusammengefügt und damit eine vergrabene isolierende Zwischenschicht aus Oxid erzeugt. Ein nachfolgender Temperaturschritt bewirkt, daß in der wasserstoffreichen Schicht eine Bläschenbildung einsetzt, durch den der überwiegende Teil des ersten Wafers abgesprengt wird. Die neue Oberfläche des SOI-Wafers wird mittels weiterer Prozessschritte von den Verunreinigungen und Defekte, die durch das Sprengen in der oberflächennahen Schicht erzeugt wurden, weitestgehend befreit, um eine Oberflächen- bzw. Schichtqualität für die Herstellung von integrierten Schaltungen zu erreichen. Die mit dem Verfahren erreichbaren Dicken, der auf der Oxidschicht aufliegenden Siliziumschicht, liegen im Bereich von 1.0 µm, und ist im Wesentlichen bestimmt von der maximal erreichbaren Eindringtiefe der Wasserstoffionen bei der Implantation.

In anderen bekannten Verfahren, beispielsweise beschrieben in der Druckschrift W.P.Maszara, Electrochem. Soc. PV 90-6, 199-212 B (1990), werden SOI-Wafer hergestellt, indem nach der Oxidation und dem Zusammenfügen der Oberfläche des ersten Wafers mit der Oberfläche des zweiten Wafers, entweder die Rückseite des ersten oder die Rückseite des zweiten Wafers bis zur gewünschten Schichtdicke, die im allgemeinen oberhalb einiger um liegt, durch dünnen oder schneiden und dünnen reduziert wird.

Der Nachteil der bisherigen Verfahren ist es, daß ein hoher Aufwand nötig ist, um die Oberfläche bzw. Schichtqualität der auf dem isolierenden Oxid aufliegenden Siliziumschicht zu verbessern. Insbesondere verursacht das Absprengen bei dem SMART-CUT Verfahren in der Oberfläche des Wafers besonders viele Kristallschäden, die mittels nachfolgenden Prozessschritten, wie beispielsweise ein mechanisches-chemisches Polieren oder Reduktionsprozessen verringert werden. Bei den anderen Verfahren ist, bedingt durch die Art der Herstellung, zusätzlich die Reinigung der Oberfläche und die Kontrolle der Schichtparameter, wie die Gleichmäßigkeit der Schichtdicke, bzw. das Herstellen von reproduzierbaren Enddicken sehr aufwendig. Ferner lassen sich vergrabene Schichten, wie z. B. "buried layer" Schichten, oder vertikale Gradienten in den Schichtparametern insbesondere bei Schichtdicken oberhalb 2 µm nicht mit vertretbarem Aufwand herstellen.

Da im dem Gebiet der Siliziumtechnologie, insbesondere im Bereich der Herstellung von integrierten Schaltungen, die Schichtqualität der Silizium-Schicht eine wichtige Voraussetzung ist, um eine vertretbare Ausbeute bei der Herstellung von integrierten Schaltungen sicherzustellen, ist es ein Ziel der Entwicklung Verfahren bereitzustellen, die eine besonders hohe Schichtqualität d.h. Gleichmäßigkeit und Defektfreiheit für Silizium-Wafer mit einer isolierenden Zwischenschicht mit vertretbarem Aufwand erzeugen. Ferner ist es wünschenswert innerhalb der oberen Siliziumschicht, Parameter wie die Leitfähigkeit, auch für dickere Siliziumschichten einfach einzustellen. Aufgabe der vorliegenden Erfindung ist es, ein derartiges Verfahren anzugeben.

Die erstgenannte Aufgabe wird durch die Merkmale des Patentanspruches 1 gelöst. Günstige Ausgestaltungsformen sind Gegenstand von Unteransprüchen.

Hiernach besteht das Wesen der Erfindung darin, ausgehend von einem Wafer, der eine isolierende Zwischenschicht aufweist, als neue Silizium-Oberfläche die Silizium-Grenzfläche der Grenzschicht Silizium-Oxid der ersten Siliziumschicht zu gewinnen. Hierzu wird ausgehend von der aus einem ersten, aus einer auf einem Träger angeordneten isolierenden Zwischenschicht und einer daran anschließenden Oberflächenschicht bestehenden Silizium-Wafer, und einem zweiten eine Oberfläche aufweisenden Silizium-Wafer, ein Silizium-Wafer mit isolierender Zwischenschicht erzeugt, indem die beiden Wafer über die jeweilige Oberfläche zusammengefügt werden, im Allgemeinen als bonden bezeichnet, und vor dem Zusammenfügen auf der Oberfläche wenigstens eines Silizium-Wafers wenigstens eine isolierende Schicht aufgebracht wird und nach dem Zusammenfügen der Träger des ersten Silizium-Wafers entfernt wird.

Es ist dabei vorteilhaft den Träger des ersten Silizium-Wafers selektiv zu der isolierenden Zwischenschicht zu entfernen, da eine selektive Entfernung mittels robuster und vergleichsweise kostengünstigen Prozeßschritten, wie beispielsweise durch einen naßchemischen Prozeß durchführbar ist. In einem nachfolgenden Prozeßschritt wird durch die Abnahme der isolierenden Zwischenschicht des ersten Wafers die bisherige Grenzfläche Siliziumisolierende Schicht, die vor dem Zusammenfügen vergraben war, als neue Silizium-Oberfläche bereitgestellt.

Der Vorteil des neuen Verfahrens gegenüber dem bisherigen Stand der Technik ist es, daß die Oberfläche von der ersten Siliziumschicht mit hoher Qualität für weitere Fertigungsverfahren, wie beispielsweise das Herstellen von integrierten Schaltungen, zur Verfügung gestellt werden, wobei keine Nachbearbeitung der obersten Siliziumschicht durchgeführt werden muß. Dabei ist das Verfahren unabhängig von der Dicke der ersten Schicht des ersten Silizium-Wafers. Insbesondere bei dickeren Schichten wird die Anforderungen an die Qualität der Oberfläche des ersten Wafers, wie beispielsweise die Gleichmäßigkeit der Schichtdicke, wesentlich reduziert, da auf die Oberfläche eine isolierende Schicht abgeschieden wird und durch das Zusammenfügen mit einem weiteren Wafer die bisherige Oberfläche vergraben und zur Grenzfläche Silizium-Isolationsschicht wird. Da der Träger und die isolierende Schicht des ersten Wafers entfernt wird, werden an den Aufbau und die Qualität dieser Schichten nur geringe Anforderungen gestellt. Ferner dient bei einer selektiven Abnahme des Träges, die Zwischenschicht nur als Stoppschicht, sodaß die Dicke der Zwischenschicht beispielsweise auch Werte unterhalb 0.1µm aufweisen kann. Durch die geringen Anforderungen an den Herstellungsprozeß des ersten Wafers wird die thermische Belastung und der Streß durch die Oxidation weitestgehend reduziert.

In einer Weiterbildung des Verfahrens ist es vorteilhaft, wenn als isolierende Schicht auf einem der beiden Wafer eine Oxidschicht erzeugt wird, da diese im Unterschied zu beispielsweise einer Nitridschicht nur geringe Zug- und Scherrkräfte auf den untenliegenden Träger ausübt. Um den Herstellungsprozeß zu vereinfachen, ist es ferner vorteilhaft, die Oxidschicht ausschließlich auf der Oberfläche des ersten Wafers herzustellen, wobei bei größeren Schichtdicken dies vorzugsweise mittels eines Abscheidungsprozesses ausgeführt wird.

In einer anderen Weiterbildung des Verfahrens, wird vor dem Zusammenfügen der Oberfläche der beiden Wafer wenigstens ein charakteristischer Parameter der Oberflächenschicht des ersten Wafers verändert. Insbesondere läßt sich durch eine Implantation oder Vorbelegung der Widerstand der ersten Siliziumschicht des ersten Wafers verändern. Eine andere Möglichkeit ist, die Schichtdicke der ersten Schicht beispielsweise mittels eines Epitaxieprozesses zu erhöhen und gleichzeitig im Schichtwiderstand der ersten Schicht ein vertikaler Gradient zu erzeugen.

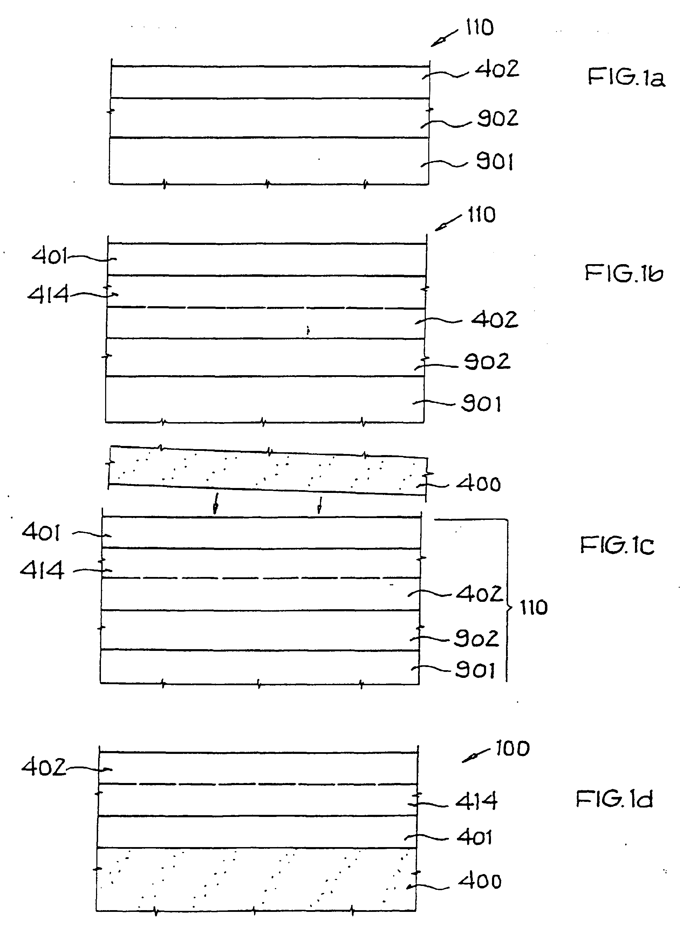

Das erfindungsgemäße Verfahren soll nachfolgend anhand eines Ausführungsbeispiels im Zusammenhang mit einer Zeichnungsfolge erläutert werden. Es zeigen die
- Fig. 1a- d: einen schematisierten Ablauf eines Herstellungsprozesses für einen Silizium-Wafer mit isolierender Zwischenschicht.

Die in Figur 1a-d dargestellte Folge von Prozeßschritten, zeigt den Herstellungsprozess eines Wafers 100 mit isolierender Zwischenschicht aus Siliziumoxid (SOI-Wafer). Derartige Wafer werden beispielsweise als Ausgangsmaterial für die Herstellung von substratstromfreien integrierten Schaltungen verwendet. Im Folgenden wird der Herstellungsprozeß im Einzelnen erläutert.
Die Figur 1a zeigt einen Querschnitt eines ersten SOI-Wafers 110. Der SOI-Wafer 110 weist einen Träger 901 aus Silizium auf, an den sich eine Oxidschicht 902 als isolierende Schicht, deren Dicke vorzugsweise zwischen 0.1 µm und 2.0 µm liegt, anschließt. An die Oxidschicht 902 schließt sich eine Schicht 402 aus Silizium an.
In einem nachfolgenden Schritt, dargestellt in Figur 1b, wird die Schichtdicke der Siliziumschicht 402, mittels einer Epitaxie, um die Dicke einer weiteren Siliziumschicht 414 erhöht. Während des Epitaxieprozesses wird die Dotierung sukzessive verändert, um ein vertikales Dotierprofil innerhalb der Siliziumschicht 414 zu erzeugen. Anschließend wird eine Oxidschicht 401 erzeugt, deren Dicke sich durch die spätere Verwendung des SOI-Wafers 100 bestimmt. Bei dünnen Oxidschichten bis etwa 0.1 µm ist es vorteilhaft, die Oxidschicht 401 auf thermischen Wege durch einen Oxidationsschritt aufzuwachsen, wobei die Dicke der Siliziumschicht 414 entsprechend verringert wird. Werden größere Oxiddicken, beispielsweise oberhalb 0.5 µm benötigt, ist es vorteilhaft, nach einem ersten dünnen thermischen Oxid, die weitere Oxidschicht mittels eines Abscheidungsprozeß zu erzeugen.
In einem nachfolgenden Prozeßschritt, dargestellt in Figur 1c, wird die Oberfläche des SOI-Wafers 110 mit der Oberfläche eines zweiten Wafers 400, der aus Kostengründen keine isolierende Oxidschicht aufweist, zusammengefügt (bonden). Eine wichtige Voraussetzung hierfür ist, daß beide Wafer eine weitestgehend planare Oberfläche aufweisen, d.h. weder konkav noch konvex verspannt sind.
In Figur 1d ist der Querschnitt des fertigen SOI-Wafers 100 dargestellt, wobei der Träger 901 des ursprünglichen SOI-Wafers 110 und die Oxidschicht 902 entfernt wurde. Die Entfernung des Trägers geschieht vorzugsweise in einer Kombination aus einem chemischmechanischen Polierschritt und einem naßchemischen Ätzschritt, wobei der naßchemische Prozeßschritt eine Selektivität in der Ätzrate zwischen Silizium und Oxid aufweist.
Mit dem erfindungsgemäßen Verfahren wird die saubere und defektfreie Oberfläche des ersten Wafers 110 als Ausgangsfläche für nachfolgende Herstellungsverfahren zur Verfügung gestellt. Weitere Nachbehandlungsschritte, um eine ausreichende Oberflächenqualität zu erreichen, entfallen. Ferner ist es möglich, die Schichtparameter der Siliziumschicht 402 gezielt zu ändern. Hierzu lassen sich Standardverfahren, wie beispielsweise Implantation, Epitaxie usw. anwenden. Ferner ist es mit dem erfindungsgemäßen Verfahren möglich, vergrabene Schichten, wie beispielsweise eine sogenannte "buried layer" Schicht zu erzeugen. Des Weiteren lassen sich, anstelle einer einzelnen Oxidschicht 401 auch unterschiedliche Schichtaufbauten, beispielsweise Kombinationen aus Nitrid-, Polysilizium- und Oxidschichten erzeugen, die dann die isolierende Zwischenschicht bilden.

## Patentansprüche

1. Verfahren zur Herstellung eines Silizium-Wafers (100), aus einem ersten aus einer auf einem Träger (901) angeordneten isolierenden Zwischenschicht (902) und einer sich daran anschließenden Oberflächenschicht (402) bestehenden Silizium-Wafer (110), und einem zweiten eine Oberfläche aufweisenden Silizium-Wafer (400), indem die beiden Wafer (110,400) über ihre jeweilige Oberfläche zusammengefügt werden,
• vor dem Zusammenfügen auf der Oberfläche wenigstens eines Silizium-Wafers (110, 400) wenigstens eine isolierende Schicht (401) aufgebracht wird, und
• nach dem Zusammenfügen der Träger (901) des ersten Silizium-Wafers (110) entfernt wird.

2. Verfahren nach Anspruch 1, **dadurch gekennzeichnet, daß** bei dem ersten Wafer (110) der Träger (901) selektiv zu der isolierenden Zwischenschicht (902) entfernt wird.

3. Verfahren nach Anspruch 1, **dadurch gekennzeichnet, daß** die isolierende Zwischenschicht (902) des ersten Wafers (110) entfernt wird.

4. Verfahren nach Anspruch 1, **dadurch gekennzeichnet, daß** als isolierende Schicht (401) vor dem Zusammenfügen auf der Oberfläche wenigstens eines der beiden Silizium-Wafer (110, 400) eine Oxidschicht erzeugt wird.

5. Verfahren nach Anspruch 4, **dadurch gekennzeichnet, daß** die Oxidschicht ausschließlich auf der Oberfläche des ersten Wafers (110), vorzugsweise durch Abscheiden erzeugt wird.

6. Verfahren nach Anspruch 1, **dadurch gekennzeichnet, daß** vor dem Zusammenfügen wenigstens einer der charakteristischen Parameter, wie beispielsweise der Widerstand oder die Dicke der Oberflächenschicht des ersten Wafers (110) verändert wird.

## Claims

1. Method of producing a silicon wafer (100), consisting of a first silicon wafer (101), which consists of an insulating intermediate layer (902) arranged on a carrier (901) and a surface layer (402) adjoining thereat, and of a second silicon wafer (400) having a surface, in that the two wafers (110, 400) are joined together by way of their respective surfaces,
- prior to the joining together at least one insulating layer (401) is applied to the surface of at least one silicon wafer (110, 400) and
- after the joining together the carrier (901) of the first silicon wafer (110) is removed.

2. Method according to claim 1, **characterised in that** in the case of the first wafer (110) the carrier (901) is selectively removed to the insulating intermediate layer (902).

3. Method according to claim 1, **characterised in that** the insulating intermediate layer (902) of the first wafer (110) is removed.

4. Method according to claim 1, **characterised in that** an oxide layer is produced on the surface of at least one of the two silicon wafers (110, 400) as insulating layer (401) before the joining together.

5. Method according to claim 4, **characterised in that** the oxide layer is produced exclusively on the surface of the first wafer (110), preferably by deposition.

6. Method according to claim 1, **characterised in that** at least one of the characteristic parameters, such as, for example, the resistance or the thickness of the surface layer of the first wafer (110), is changed before the joining together.

## Revendications

1. Procédé de fabrication d'une plaquette de silicium (100) à partir d'une première plaquette de silicium (110) composée d'une couche intermédiaire (902) isolante disposée sur un support (901) et d'une couche de surface (402) contiguë, et d'une deuxième plaquette de silicium (400) présentant une surface, selon lequel les deux plaquettes (110, 400) sont jointes par leurs surfaces respectives, selon lequel, avant l'assemblage, on applique sur la surface d'au moins une plaquette de silicium (110, 400) au moins une couche isolante (401), et l'on enlève le support (901) de la première plaquette de silicium (110) après assemblage.

2. Procédé selon la revendication 1, **caractérisé en ce que** dans la première plaquette (110) le support (901) est enlevé sélectivement par rapport à la couche intermédiaire (902) isolante.

3. Procédé selon la revendication 1, **caractérisé en ce que** l'on enlève la couche intermédiaire (902) isolante de la première plaquette (110).

4. Procédé selon la revendication 1, **caractérisé en ce qu'**avant assemblage, on produit comme couche isolante (401) une couche d'oxyde à la face supérieure d'au moins une des deux plaquettes de silicium (110, 400).

5. Procédé selon la revendication 4, **caractérisé en ce que** l'on produit la couche d'oxyde uniquement sur la face supérieure de la première plaquette (110), de préférence par dépôt.

6. Procédé selon la revendication 1, **caractérisé en ce qu'**avant assemblage, on modifie au moins un des paramètres caractéristiques tels que, par exemple, la résistance ou l'épaisseur de la couche de surface de la première plaquette (110).
